# EUROPÄISCHE PATENTSCHRIFT

(11) **EP 2 105 750 B1**
(45) Veröffentlichungstag und Bekanntmachung des Hinweises auf die Patenterteilung: **19.01.2011**
(21) Anmeldenummer: 08005967.8
(22) Anmeldetag: 28.03.2008
(51) Int. Cl.: G01R 31/317

(54) **Schaltungsanordnung, Vorrichtung bzw. Verfahren zum seriellen Senden von Daten über einen Anschlusskontakt**
Switch assembly, device and method for serial transmission of files through a connector
Agencement de commutation, dispositif ou procédé d'émission série de données par l'intermédiaire d'un contact de raccordement

(43) Veröffentlichungstag der Anmeldung: 30.09.2009
(73) Patentinhaber: Micronas GmbH, 79108 Freiburg i. Br. (DE)
(72) Erfinder: Rubehn, Thilo, 79194 Gundelfingen (DE); Ritter, Joachim, 79540 Lörrach (DE); Umbach, Gert, 79194 Gundelfingen (DE); Bächer, Dieter, 79350 Sexau (DE); Horn, Wolfgang, Dr., 9020 Klagenfurt (AT); Franke, Jörg, 79117 Freiburg (DE)
(74) Vertreter: Koch Müller Patentanwaltsgesellschaft mbH

(56) Entgegenhaltungen:
- DE-A1-102006 022 985
- DE-C1- 19 819 265
- US-A1- 2004 210 805
- US-A1- 2007 216 438

## Beschreibung

Die Erfindung bezieht sich zum seriellen Senden von Daten über einen Anschlusskontakt auf eine Schaltungsanordnung mit den oberbegrifflichen Merkmalen gemäß Patentanspruch 1, auf eine Vorrichtung mit den oberbegrifflichen Merkmalen gemäß Patentanspruch 9 bzw. auf ein Verfahren mit den oberbegrifflichen Merkmalen gemäß Patentanspruch 13.

DE 198 19 265 C1 beschreibt ein Verfahren zum Parametrieren einer integrierten Schaltungsanordnung sowie eine integrierte Schaltungsanordnung dafür. Ausgegangen wird dabei von einer integrieren Schaltungsanordnung, welche im Wesentlichen fest verdrahtete bzw. fest verbundene Komponenten aufweist. Durch eine Parametrisierung können Parameter für den Betrieb der Schaltungsanordnung vorgegeben werden. Zur Eingabe der Parameter dient ein Signalspannungsanschluss, an welchem eine Signalspannung anliegt. Die eigentlichen Parameter werden der Signalspannung aufmoduliert, wobei ein dem Signalspannungsanschluss nachgeschalteter Komparator die anliegende Signalspannung daraufhin prüft, ob diese über einen Schwellenwert hinaus ansteigt.

Allgemein bekannt sind außerdem Gehäuse mit einer großen Vielzahl an Anschlusskontakten in Form von so genannten Pins, wobei die Gehäuse zur Aufnahme von unter anderem integrierten Schaltungskomponenten dienen. Bekannt ist dabei, einen frei programmierbaren digitalen Prozessor mit weiteren für den Betrieb eines Prozessors erforderlichen Komponenten in dem Gehäuse aufzunehmen. Üblicherweise dienen dabei zwei Anschlusskontakte des Gehäuses zum Anlegen einer Versorgungsspannung und einer Basisspannung, zwei weitere Anschlusskontakte zum Anlegen eines Erdanschlusses bzw. einer Null-Spannung und einer Betriebsspannung sowie eine Vielzahl weiterer Anschlusskontakte zum Ein- oder Ausgeben von Daten.

Solche Schaltungsanordnungen und auch sonstige integrierte Schaltungsanordnungen verwenden für Test- bzw. Prüfzwecke entweder nur aus einem entsprechenden Gehäuse geführte Signal-Anschlusskontakte zum parallelen oder seriellen Testen oder Nutzen, sofern nur wenige Anschlusskontakte vorhanden sind, eine einfache einpegelige Modulation der Versorgungsspannung gemäß DE 198 19 265 C1 und/oder eine einfache Modulation der Stromaufnahme.

Um einen schnellen unidirektionalen seriellen und synchronen Test einer integrierten Schaltungsanordnung vornehmen zu können, beschreibt DE 10 2006 022 985 A1 eine Schaltungsanordnung mit einer seriellen Test-Schnittstelle zum Ansteuern einer Testbetriebsart, mit einem frei programmierbaren digitalen Prozessor, mit einem Gehäuse zur Aufnahme der Test-Schnittstelle und des Prozessors und mit Anschlusskontakten für einen Daten- und/oder Signalaustausch mit externen Komponenten und Einrichtungen, wobei an einem der Anschlusskontakte eine modulierte Signalspannung anlegbar ist zum Übertragen von Daten und/oder einem Takt unter Verwendung von zumindest zwei Spannungspegeln, welche ansteuerbar sind. Mittels zumindest zweier Komparatoren ist das Über- und/oder Unterschreiten der beiden Spannungspegel bereits detektierbar.

Bei integrierten Schaltungsanordnungen mit sehr wenigen Kontaktstiften bzw. PINs ist jeder Extra-PIN verhältnismäßig teuer. Wichtig ist daher, eine vollsynchrone, bidirektionale Kommunikation bei Schaltungsanordnungen für Testzwecke der Schaltungsanordnungen selber über eine möglichst geringe Anzahl an Kontaktstiften zu ermöglichen.

Gegenüber dem früheren Stand der Technik beseitigt DE 10 2006 022 985 A1 Nachteile, indem die Übertragung eines Taktes und zusätzlich von Daten seitens einer übergeordneten Vorrichtung zu der Schaltungsanordnung über eine Spannungsversorgung erfolgt. Für eine Testbetriebsart kann auf eine eigenständige Taktquelle in der integrierten Schaltungsanordnung verzichtet werden, solange diese getestet wird. Ermöglicht wird dabei bereits auch ein Takt, welcher gleich-frequent in die integrierte Schaltungsanordnung übertragen wird. Jedoch handelt es sich nur um eine unidirektionale Übertragung von Daten und somit eine nur unidirektional spannungsmodulierende Schnittstelle. Für eine Übertragung von Daten oder gegebenenfalls auch Sensordaten im eigentlichen Betrieb seitens der integrierten Schaltungsanordnung an eine übergeordnete Vorrichtung ist entweder eine aufwendig zu gestaltende Strommodulation an dem Versorgungsspannungsanschluss oder der Einsatz eines zusätzlichen Kontaktstifts bzw. PINs erforderlich.

Die Aufgabe der Erfindung besteht darin, zum seriellen Senden von Daten über einen Anschlusskontakt eine verbesserte Schaltungsanordnung, eine zur Kommunikation damit ausgestaltete Vorrichtung bzw. ein dafür verbessertes Verfahren vorzuschlagen, welche auch bei integrierten Schaltungsanordnungen mit einer reduzierten Anzahl von insbesondere nur zwei Anschlusskontakten ohne Verlust von möglichen Funktionalitäten oder Kapazitäten einsetzbar sind. Insbesondere soll eine Testbetriebsart in einer Schaltungsanordnung gemäß DE 10 2006 022 985 A1 so verbessert werden, dass zwei Spannungskontaktstifte zusätzlich zu einer Spannungsversorgung auch eine bidirektionale Datenübertragung bei zugleich geringem baulichem Aufwand ermöglichen.

Diese Aufgabe wird zum seriellen Senden von Daten über einen Anschlusskontakt durch eine Schaltungsanordnung den Merkmalen gemäß Patentanspruch 1, durch eine Vorrichtung mit den Merkmalen gemäß Patentanspruch 9 bzw. durch ein Verfahren mit den Merkmalen gemäß Patentanspruch 13 gelöst. Vorteilhafte Ausgestaltungen sind Gegenstand von abhängigen Ansprüchen.

Bevorzugt wird demgemäß eine integrierte Schaltungsanordnung mit Anschlusskontakten für einen seriellen Daten- und/oder Signalaustausch mit externen Komponenten und Vorrichtungen und mit einer Steuereinrichtung und/oder einer seriellen Schnittstelle zum mittels eines Takts getakteten Empfangen von Daten mittels einer zwischen zumindest einem tiefen, einem mittleren und einem hohen Spannungszustand modulierten Signalspannung an einem solchen Anschlusskontakt. Vorteilhaft wird diese dadurch, dass die Steuereinrichtung und/oder die Schnittstelle eine Schalteinrichtung aufweisen, wobei diese derart ausgestaltet und/oder angesteuert sind, dass in einem Sendemodus über diesen Anschlusskontakt Daten gesendet werden, indem die Schalteinrichtung nach Empfang einer von einem der Spannungszustände in einen anderen der Spannungszustände wechselnden Flanke diesen anderen der Spannungszustände vor zeitlichem Ablauf eines halben Taktzyklus des Takts in einen der aus Sicht dieses anderen der Spannungszustände verschiedenen der Spannungszustände zieht.

Insbesondere werden in dem Sendemodus über diesen Anschlusskontakt Daten gesendet, indem die Schalteinrichtung nach Empfang einer von dem mittleren Spannungszustand in den höheren oder den tieferen Spannungszustand wechselnden Flanke den Spannungszustand vor zeitlichem Ablauf eines halben Taktzyklus des Takts in den aus Sicht des mittleren Spannungszustands entgegengesetzten des tieferen oder höheren Spannungszustands zieht.

Auf überraschend einfache Art und Weise kann durch eine solche Ausgestaltung eine Strommodulation an dem Spannungsanschluss zur Rückübertragung von Daten seitens der integrierten Schaltungsanordnung zu einer übergeordneten Vorrichtung entfallen. Auch das Bereitstellen eines zusätzlichen Kontaktstifts bzw. PINs zum Übertragen von Daten aus der Schaltungsanordnung in die übergeordnete Vorrichtung ist nicht mehr erforderlich. Ermöglicht wird auf einfache Art und Weise eine vollsynchrone, bidirektionale Kommunikation über nur einen einzelnen Kontaktstiftt. Das heißt, über vorzugsweise eine einzige Signalleitung sollen gleichzeitig Daten in beiden Richtungen und insbesondere zusätzlich ein Takt zur synchronen Verarbeitung der Daten übertragen werden. Vorteilhafterweise ist dadurch auch nur auf einer der beiden Seiten ein Arbeitstakt notwendig, wobei der Takt für die Eindraht-Schnittstelle vorzugsweise extern der integrierten Schaltungsanordnung von der übergeordneten Vorrichtung bereitgestellt wird. Auf der Taktempfängerseite, das heißt in der Eindraht-Schnittstelle intern der Schaltungsanordnung muss kein eigener Takt vorhanden sein. In üblicher Art und Weise ist daneben gegebenenfalls eine Masse- bzw. Basisspannungsverbindung oder ein gemeinsamer Masseanschluss vorhanden.

Bevorzugt wird eine solche Schaltungsanordnung mit einer Komparatorschaltung, welche ausgestaltet und/oder angesteuert ist sowohl der Signalspannung aufmodulierte Daten als für die Schaltungsanordnung interne Daten als auch einen der Signalspannung aufmodulierten Takt als für die Schaltungsanordnung internen Takt zu extrahieren.

Ausgestattet ist die Schaltungsanordnung bevorzugt mit einer schaltungsanordnungsseitigen Sendesteuerung, welche einen Zähler, z.B. ein Schieberegister, zum Zählen einer Anzahl von Takten mit von der Vorrichtung gesendeten Daten oder Spannungszuständen zu aufweist und Komponenten zum Senden der Daten an die Vorrichtung bei Erreichen eines festen oder vorgebbar festen Zählerwerts des Zählers aufweist.

Vorteilhaft ist die Schaltungsanordnung mit einer Transistoranordnung zum schwachen Ziehen der Signalspannung in den anderen, insbesondere entgegengesetzten Spannungszustand und einer Transistoranordnung zum starken Ziehen der Signalspannung in den anderen, insbesondere entgegengesetzten Spannungszustand. Dadurch kann die angelegte Signalspannung mit unterschiedlicher Kraft in eine gewünschte Richtung gezogen werden. Das schwache Ziehen ermöglicht insbesondere eine rezessive Spannungsänderung anzusteuern, welche durch die kommunizierende Vorrichtung im Gegensatz zu einem starken Ziehen leicht übersteuert werden kann.

Eine solche Schaltungsanordnung kann vorteilhaft für eine Testbetriebsart ausgelegt und/oder gesteuert sein zum Anlegen des mit der Signalspannung angelegten Takts als internen Takt an Komponenten der Schaltungsanordnung. Somit wird für die interne Schaltung der Takt als ein Arbeitstakt bereitgestellt. Dieser Takt entsteht durch die Modulation der Signalspannung. D.h. die interne Schaltung kann nach jeder durch die übergeordnete Vorrichtung als einem externen Clockmaster generierten Flanke direkt reagieren. Die interne Schaltung kann insbesondere einen von extern angestrebten mittleren Spannungspegel gegen einen niedrigeren oder auch einen höheren Pegel verziehen. Beschrieben ist nachfolgend beispielhaft das Verziehen eines hohen in einen niedrigen Pegel. Dadurch muss die integrierte Schaltu nicht zwingend über eine eigene Taktquelle verfügen bzw. in einer Testbetriebsart eine Synchronisierung einer eigenen Taktquelle und einer externen Taktquelle der prüfenden Vorrichtung durchführen.

Bevorzugt wird eine solche Schaltungsanordnung mit einer Schalteinrichtung zum Aktivieren einer Komparatorschaltung zum Analysieren der Signalspannung und/oder einer Test-Schnittstelle in einer Testbetriebsart und/oder bei einer Entwicklung der Schaltungsanordnung und/oder bei einer Entwicklung der Software der Schaltungsanordnung und/oder bei einer Bandendeprogrammierung und/oder bei einer Fehlersuche in einer durch die Schaltungsanordnung realisierten Applikation. Dadurch kann beispielsweise auf einfache Art und Weise zwischen einer Testbetriebsart und einer regulären Betriebsart umgeschaltet werden.

Eine solche Schaltungsanordnung kann bevorzugt mit z.B. einer Sensoranordnung ausgestattet sein und ausgelegt und/oder gesteuert sein zum Ausgeben von durch die Schaltungsanordnung oder eine daran angeschlossene Anordnung bereitgestellten Daten, insbesondere Mess- oder Sensordaten, als den in dem Sendemodus über den Anschlusskontakt zu sendenden Daten. So kann ein durch eine übergeordnete Vorrichtung ansteuerbarer Sensor mit nur drei Anschlusskontakten über diese mit der Signalspannung versorgt werden, Daten zu seiner Steuerung empfangen und Testergebnisse und/oder Messwerte als Daten senden.

Eigenständig vorteilhaft ist eine Vorrichtung mit Anschlusskontakten für einen seriellen Daten- und/oder Signalaustausch mit einer integrierten Schaltungsanordnung, einer derart bevorzugten Schaltungsanordnung, wenn die der Schaltungsanordnung übergeordnete Vorrichtung ausgestattet ist mit einer Steuereinrichtung und/oder einer seriellen Schnittstelle zum mittels eines Takts getakteten Senden von Daten durch Modulation einer Signalspannung zwischen zumindest einem tiefen, einem mittleren und einem hohen Spannungszustand an einem solchen Anschlusskontakt, wenn die Schnittstelle derart ausgestaltet und/oder angesteuert ist, dass diese in einem Empfangsmodus von einem der Spannungszustände in einen anderen der Spannungszustände wechselt und diese zumindest bei einem Ziehen diesen anderen der Spannungszustände vor zeitlichem Ablauf eines halben Taktzyklus des Takts in einen der aus Sicht dieses anderen der Spannungszustände verschiedenen der Spannungszustände durch die Schaltungsanordnung einen Empfang von Daten von der Schaltungsanordnung erfasst.

Insbesondere ist die Schnittstelle derart ausgestaltet und/oder angesteuert, dass diese in einem Empfangsmodus von dem mittleren Spannungszustand als dem einen Spannungszustand in den höheren oder den tieferen Spannungszustand als dem anderen Spannungszustand wechselt und zumindest bei einem Ziehen des Spannungszustands vor zeitlichem Ablauf eines halben Taktzyklus des Takts in den aus Sicht des mittleren Spannungszustands entgegengesetzten des tieferen oder höheren Spannungszustands durch die Schaltungsanordnung einen Empfang von Daten von der Schaltungsanordnung erfasst.

Bevorzugt ist dabei die Schnittstelle ausgelegt und/oder angesteuert ist zum rezessiven Anlegen der Signalspannung beim Wechsel in den anderen der Spannungszustände, insbesondere in den höheren oder den tieferen Spannungszustand als dem anderen Spannungszustand während des Empfangsmodus. Ein rezessiven Spannungszustand ermöglicht der angeschlossenen integrierten Schaltung auf einfache Art und Weise, die Signalspannung in einen anderen Spannungszustand zu ziehen, um so eine Signalisierung von Daten durchzuführen.

Einsetzbar sind entsprechend in einem System zum Übertragen von Daten oder Signalen über einen gemeinsamen mit Anschlusskontakt bevorzugt eine solche bevorzugte integrierte Schaltungsanordnung und eine solche bevorzugte Vorrichtung.

Eigenständig vorteilhaft ist ein Verfahren zum seriellen Übertragen von Daten durch Modulation einer Signalspannung zwischen zumindest einem tiefen, einem mittleren und einem hohen Spannungszustand an einem Anschlusskontakt einer integrierten Schaltungsanordnung, wenn in einem Empfangsmodus durch eine an den Anschlusskontakt geschaltete Vorrichtung an diesen Anschlusskontakt die Signalspannung mit einem der Spannungszustände in einen anderen der Spannungszustände wechselnden Flanke angelegt wird und durch die Schaltungsanordnung zum Senden nach Empfang der Flanke die Signalspannung in einen der aus Sicht dieses anderen der Spannungszustände verschiedenen der Spannungszustände gezogen wird.

Bevorzugt wird ein solches Verfahren, bei dem durch die Vorrichtung die Flanke an den Anschlusskontakt angelegt wird und einerseits durch die Schaltungsanordnung zum Senden eines ersten Datenzustands nach Empfang der Flanke die Signalspannung in den aus Sicht des mittleren Spannungszustands als dem einen der Spannungszustände entgegengesetzten des tieferen oder höheren Spannungszustands als dem einen anderen der Spannungszustände gezogen wird und andererseits zum Senden eines zweiten Datenzustands nach Empfang der Flanke die Signalspannung in dem durch die Vorrichtung angelegten Spannungszustand belassen wird. Ein Protokoll, welches einen solchen Ablauf berücksichtigt, ermöglicht ein direktes Senden von Daten durch die Vorrichtung an die Schaltungsanordnung zu entsprechend vorgegebenen Zeitpunkten oder Takten durch Anlegen von hohen Spannungszuständen bzw. tiefen Spannungszuständen, welche als solche durch die Schaltungsanordnung interpretiert werden. In umgekehrter Richtung erfolgt hingegen ein indirektes Senden von Daten mittels aufeinanderfolgender Daten- bzw. Spannungszustände, bei dem die Schaltungsanordnung nach dem Empfang der Flanke wahlweise den Spannungszustand belässt oder in den anderen Spannungszustand zieht.

Bevorzugt wird die Signalspannung mittels eines Takts getaktet verändert wird, wobei durch die integrierte Schaltungsanordnung nach Empfang der Flanke die Signalspannung vor zeitlichem Ablauf eines halben Taktzyklus des Takts in den aus Sicht des mittleren Spannungszustands als dem einen der Spannungszustände entgegengesetzten des tieferen oder höheren Spannungszustands als dem einen anderen der Spannungszustände gezogen wird.

Bevorzugt eingesetzt wird dabei ein Protokoll, gemäß dem eine feste Anzahl von aufeinander folgenden Zeitpunkten oder Takten Taktzyklen durch die Vorrichtung gesendet werden darf und danach oder abwechselnd damit eine feste Anzahl von aufeinander folgenden Zeitpunkten oder Taktzyklen, zumindest einen Taktzyklus, durch die Schaltungsanordnung gesendet werden darf.

Durch die Vorrichtung wird zum Übertragen eines Takts an die Schaltungsanordnung bevorzugt die Signalspannung innerhalb eines Taktzyklus getaktet verändert durch einen Wechsel des Spannungszustands der Signalspannung zwischen zweien des mittleren Spannungszustands, des höheren Spannungszustands oder des tieferen Spannungszustand und durch einen Wechsel des Spannungszustands zurück.

Ein Ausführungsbeispiel wird nachfolgend anhand der Zeichnung näher erläutert. Es zeigen:
- Fig. 1: Komponenten einer integrierten Schaltungsanordnung, welche über zwei Spannungs-Kontaktstifte an eine über- geordnete Vorrichtung, beispielsweise eine Prüfschal- tung, angeschlossen sind,
- Fig. 2: einen Spannungsverlauf, welcher an einem Signalspan- nungsanschluss zwischen der übergeordneten Vorrichtung und der integrierten Schaltungsanordnung beispielhaft messbar ist,
- Fig. 3: Spannungszustände zum Übertragen einer logischen Eins und einer logischen Null,
- Fig. 4: eine beispielhafte Schaltungsanordnung für einen Kom- parator zum Extrahieren von Daten und einem Takt aus einer angelegten Signalspannung,
- Fig. 5: verschiedene Signal- bzw. Taktverläufe zur Verdeutli- chung einer Verfahrensweise zur Modulation bzw. Demo- dulation einer Signalspannung,
- Fig. 6: einen beispielhaften Spannungsverlauf beim Empfang ei- nes Bits durch die integrierte Schaltungsanordnung,
- Fig. 7: einen beispielhaften Spannungsverlauf für einen Sende- zustand der Schaltungsanordnung und
- Fig. 8: Komponenten eines beispielhaften Schaltungsdiagramms einer Steuereinrichtung zum Bereitstellen von Steuer- signalen für eine Schalteinrichtung zum Senden von Da- ten seitens der Schaltungsanordnung zu der übergeord- neten Vorrichtung.

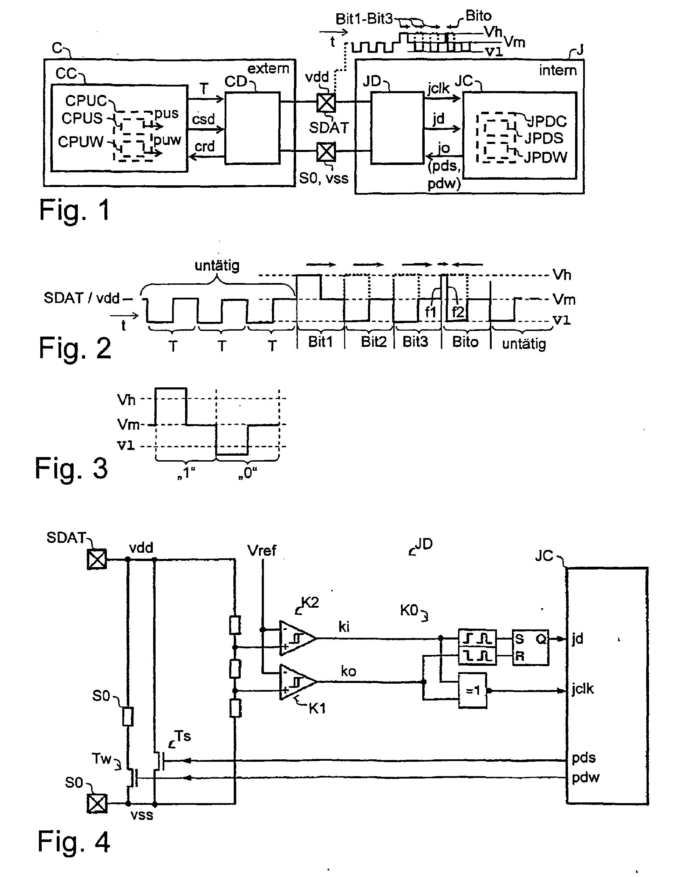

Fig. 1 zeigt schematisch eine integrierte Schaltungsanordnung J bzw. Komponenten einer solchen integrierten Schaltungsanordnung J, welche an eine übergeordnete Vorrichtung C als einer externen Vorrichtung aus Sicht der Schaltungsanordnung angeschlossen ist.

Idealerweise erfolgt die Verbindung dabei insbesondere für eine Testbetriebsart über nur zwei Anschlusskontakte S0, SDAT, welche als Kontaktstifte zur Übertragung einer Basisspannung vss bzw. einer Signalspannung v dienen. Entsprechend weisen sowohl die integrierte Schaltungsanordnung J als auch die übergeordnete Vorrichtung C jeweils eine serielle Schnittstellenschaltung JD, CD auf. Unter der Basisspannung vss kann ein Masseanschluss aber auch eine auf beliebig festgelegtem Spannungsniveau angelegte Spannung verstanden werden. Unter der Signalspannung v wird eine Spannung verstanden, welche relativ zu der Basisspannung vss auf einem höher oder tiefer liegenden Spannungsniveau liegt.

In der übergeordneten Vorrichtung C übernimmt eine Steuereinrichtung CC neben gegebenenfalls weiteren Funktionen eine Bereitstellung eines Takts T und von Daten csd, welche über die Schnittstelle CD der übergeordneten Vorrichtung C an die Schaltungsanordnung J zu übertragen sind. Außerdem werden seitens der Schnittstelle CD empfangene Daten crd an die Steuereinrichtung der übergeordneten Vorrichtung C weitergeleitet. Solche empfangene Daten crd werden ebenfalls über die vorzugsweise nur zwei Anschlusskontakte bzw. insbesondere den zweiten der Anschlusskontakte SDAT von der integrierten Schaltungsanordnung J empfangen.

Die integrierte Schaltungsanordnung J weist intern ebenfalls eine Schnittstelle JD zur seriellen Übertragung von Daten jo aus dieser Schaltungsanordnung J über den zweiten Anschlusskontakt SDAT zu der übergeordneten Vorrichtung C bzw. zum Empfangen eines Takts T und von Daten csd aus der übergeordneten Vorrichtung C auf. Entsprechend stellt die Schnittstelle der Schaltungsanordnung J für ihre Steuereinrichtung JC, welche zugleich als eine Sendesteuerung dient, Daten JD und einen internen Takt jclk bereit, welcher zuvor aus einem über den insbesondere zweiten Anschlusskontakt SDAT von der übergeordneten Vorrichtung C empfangenen Takt T gewonnen wurde. Die Sendesteuerung JC der integrierten Schaltungsanordnung verarbeitet somit diese empfangenen Daten vorzugsweise mit Hilfe des empfangenen Taktes T als einem daraus generierten internen Takt jclk der integrierten Schaltungsanordnung J weiter. Außerdem stellt die Steuereinrichtung JC als Sendesteuerung neben zu übertragenden Daten auch entsprechende Steuersignale für die Schnittstelle JD bereit, so dass die Schnittstelle JD der Schaltungsanordnung zu übertragende Daten jo über den zweiten Anschlusskontakt SDAT an die übergeordnete Vorrichtung C übertragen kann.

Fig. 1 skizziert einen beispielhaften Spannungsverlauf über die Zeit t an dem zweiten Anschlusskontakt SDAT, wobei der Spannungsverlauf vergrößert auch in Fig. 2 skizziert ist. Erkennbar ist, dass die Signalspannung v im Wesentlichen drei verschiedene Spannungspegel bzw. Spannungszustände V1, Vm bzw. Vh ansteuert.

In einem ersten zeitlichen Abschnitt ist ein untätiger Bereich skizziert, wobei im Wesentlichen eine Rechteckspannung zwischen den beiden unteren Spannungszuständen V1 bzw. Vm alterniert. Nachfolgend sind vier Bit Bit1, Bit2, Bit3, Bito skizziert, welche zur Kommunikation dienen. Jedes dieser Bit dauert dabei, wie auch aus Fig. 3 erkennbar, über einen ganzen Taktzyklus T des Takts T der übergeordneten Vorrichtung C.

Gemäß einem bevorzugten Protokoll dienen die ersten drei Bit Bit1 - Bit3 zur Übertragung von der übergeordneten Vorrichtung C zu der daran angeschlossenen integrierten Schaltungsanordnung J. Zur Kenntlichmachung eines aktiven Betriebszustands wechselt dabei das erste Bit Bit1 mit einer ansteigenden Flanke bis in den höchsten, dritten Spannungszustand Vh. Die beiden nachfolgenden Takte bzw. Bit Bit2, Bit3 dienen zur Übertragung von Daten csd von der übergeordneten Vorrichtung C zu der daran angeschlossenen Schaltungsanordnung J. Je nach zu übertragendem Datenzustand wird dabei alternierend zwischen dem mittleren Spannungszustand Vm und entweder dem tiefen oder dem hohen Spannungszustand V1 bzw. Vh gewechselt. Der vierte Takt T bzw. das vierte Bit Bito dient zur Übertragung von Daten in Gegenrichtung, das heißt von der integrierten Schaltungsanordnung J zu der übergeordneten Vorrichtung C. Danach folgt wieder eine Phase der Untätigkeit bzw. Inaktivität.

Das erste Bit Bit1 dient nach einer Untätigkeitszeit somit als ein Startsignal oder als ein Startbit eines entsprechenden Datenrahmens aus beispielsweise insgesamt vier Bit einschließlich dem Startbit. Pro Datenrahmen sind vorliegend dem Startbit folgend die beiden Bit Bit2, Bit3 zur Übertragung von der übergeordneten Vorrichtung zur angeschlossenen Schaltungsanordnung und ein abschließendes Bit Bito zur Übertragung von Daten in entgegengesetzter Richtung vorgesehen.

Entsprechend weist die integrierte Schaltungsanordnung J in ihrer Steuereinrichtung JC entsprechend einen Herunterziehtreiber JPDC auf, welcher mit insbesondere einem schwachen Herunterziehtreiben JPDW und einem starken Herunterziehtreiber JPDS ein schwaches bzw. ein starkes Herunterziehsignal pdw, pds an die Schnittstelle JD anlegt. Abhängig von dem anliegenden Signal zieht die Schnittstelle JD nach der ersten Flanke f1 am Ende des dritten Takts oder zu Beginn des vierten Takts Bito zum Senden eines Nullzustands die Signalspannung v auf den tiefen Spannungszustand V1.

Um eine Übertragung von der Schaltungsanordnung J zu der übergeordneten Vorrichtung C zu ermöglichen, legt die Schnittstelle CD der übergeordneten Vorrichtung C am Ende des dritten Takts oder zu Beginn des vierten Takts eine steigende Flanke f1 an, so dass die Signalspannung v von dem mittleren Spannungszustand Vm zu dem hohen Spannungszustand Vh wechselt.

Für die Schaltungsanordnung J bestehen nun zwei Übertragungsmöglichkeiten, d.h. einen hohen oder einen tiefen Zustand zu übertragen. Wünscht die Schaltungsanordnung J einen hohen Zustand bzw. eine binäre Eins zu übertragen, belässt die Schaltungsanordnung J die Signalspannung v im hohen Spannungszustand Vh. Nach einem halben Taktzyklus zieht die Schnittstelle CD der übergeordneten Vorrichtung dann die Signalspannung v wieder für einen weiteren halben Taktzyklus auf den mittleren Spannungszustand Vm. Wünscht die Schaltungsanordnung hingegen einen tiefen Zustand bzw. eine binäre Null zu übertragen, zieht sie nach der in den hohen Spannungszustand Vh wechselnden ersten ansteigenden Flanke f1 die Signalspannung in den tiefen Spannungszustand V1, wodurch der ansteigenden Flanke f1 zeitlich möglichst nahe eine abfallende zweite Flanke f2 folgt.

Alternativ zu dem Herunterziehen bis in den niedrigen Spannungszustand V1 besteht auch die Möglichkeit, dass die integrierte Schaltungsanordnung die zweite Flanke f2 nur bis zu dem mittleren Spannungszustand Vm herunterzieht. Eine entsprechende Ausgestaltung ist jedoch mit Blick auf eine Taktregenerierung in der integrierten Schaltungsanordnung J aufwendiger zu gestalten. Verallgemeinert ist umsetzbar, dass bei der Modulation nicht nur von dem mittleren Spannungszustand Vm in den hohen oder den tiefen Spannungszustand Vh, V1 gewechselt werden kann, sondern dass die Zuordnung der drei Spannungszustände V1, Vm und Vh beliebig festgelegt werden kann. Beispielsweise kann so auch zur Übertragung des Takts T auch zwischen dem hohen und dem tiefen Spannungszustand Vh, Vl gewechselt werden und zur Übertragung der Daten csd, jo ein Wechsel in den mittleren Spannungszustand Vm verwendet werden.

Um eine derartige bidirektionale Datenübertragung zu ermöglichen, weist die übergeordnete Vorrichtung C in ihrer Steuereinrichtung CC oder als eigenständige Komponente einen Hochziehtreiber CPUC auf. Dieser versorgt die Schnittstelle CD mit entsprechenden Hochziehsignalen pus, puw, aufgrund derer die Schnittstelle CD die Signalspannung v entsprechend ansteuert. Insbesondere stellt in dem Hochziehtreiber CC ein schwacher Hochziehtreiber CPUS ein schwaches Hochziehsignal pus und ein starker Hochziehtreiber CPUW ein starkes Hochziehsignal puw bereit. Vorzugsweise wird außerdem ein starkes Signal zum Ziehen eines starken mittleren Spannungszustands für die jeweils zweite Hälfte eines Taktes T bereitgestellt.

In insbesondere dem vierten Takt bzw. beim vierten Bit Bito steuert die Schnittstelle CD abhängig von einem angelegten schwachen Hochziehsignal csd die Signalspannung v auf einen hohen aber rezessiven Spannungszustand Vh, so dass die angeschlossene integrierte Schaltungsanordnung J den hohen Spannungszustand Vh wieder herunterziehen kann. Alternativ könnte anstelle einer entsprechend ausgestalteten niederpegeligdominanten Kommunikationsleitung das Verfahren entsprechend auch unter Verwendung einer hochpegelig-dominanten Kommunikationsleitung implementiert werden.

Zum Betreiben der dargestellten integrierten Schaltungsanordnung J wird dieser eine Signalspannung v angelegt. Dazu ist der erste der Anschlusskontakte S0 beispielsweise mit einer Basisspannung vss verbunden und am zweiten der Anschlusskontakte SDAT die Signalspannung v angelegt.

Bei dem dargestellten Ausführungsbeispiel wird gemäß dem skizzierten Spannungs-Zeitdiagramm die angelegte Signalspannung v über den Verlauf der Zeit t moduliert. Beispielsweise soll als Signalspannung v für die integrierte Schaltungsanordnung J ein erster Spannungspegel als ein erster Spannungszustand Vl oder ein demgegenüber niedriger Spannungspegel erforderlich sein. Die Modulation von Daten csd, welche von der übergeordneten Vorrichtung C an die Schaltungsanordnung J zu übertragen sind, erfolgt dadurch, dass zur Datenübertragung eine variierende Signalspannung v mit einem höheren Spannungspegel als dem ersten Spannungszustand Vl angelegt wird. Insbesondere werden vorzugsweise zwei oder auch mehr höhere Spannungspegel als mittlerer Spannungszustand Vm bzw. höherer Spannungszustand Vh in einem Protokoll implementiert, so dass nicht nur reine Daten sondern vorzugsweise auch ein Takt P mittels der Signalspannung v übertragen werden kann. Die Schnittstellenschaltungen CD, JD nehmen gemäß der bevorzugten Ausführungsform eine Umsetzung einer seriellen Datenübertragung auf eine parallele Datenübertragung vor bzw. in umgekehrter Richtung zur Ausgabe der mittels des Sensors S gemessenen Daten oder sonstiger Daten eine Umsetzung paralleler Daten auf serielle Daten vor.

Um die Spannungspegel analysieren zu können, das heißt die mittels der Signalspannung v übertragenen Daten csd bestimmen zu können, weist die in Fig. 4 beispielhaft dargestellte Schnittstellenschaltung JD der Schaltungsanordnung J eine Komparatorschaltung K auf.

Angelegt werden insbesondere an entsprechenden Eingängen der Komparatorschaltung K die Basisspannung vss und die mit variierendem Pegel anliegende Signalspannung v, welche von der Schnittstellenschaltung JD und/oder direkt von den beiden Anschlusskontakten S0, SDAT abgegriffen werden.

Eine Widerstandkette ist mit drei Widerständen R in Reihe zwischen die Basisspannung vss und die Signalspannung v geschaltet.

Ein erster Komparator K1 der Komparatorschaltung K weist zwei Eingänge auf, wobei an einen positiven Eingang ein Knoten geschaltet ist, der zwischen die aus Sicht der Basisspannung vss beiden ersten Widerstände R geschaltet ist. Ein negativer Eingang des ersten Komparators K1 ist an eine Referenzspannung Vref angelegt. Die Referenzspannung Vref kann beispielsweise ein interner Spannungswert sein, welcher auf mittigem Spannungsniveau zwischen dem ersten und dem dritten Spannungspegel, vorzugsweise etwa auf Höhe des mittleren Spannungszustands Vm liegt. Die Referenzspannung Vref kann z.B. eine intern mit einem Bandgap über Temperatur und Spannung generierte Spannung sein.

Ein zweiter Komparator K2, weist ebenfalls zwei Eingänge auf, wobei der negative Eingang an die Referenzspannung Vref geschaltet ist. Der positive Eingang ist an einen Knoten geschaltet, der aus Sicht der Basisspannung vss zwischen den zweiten und den dritten der Widerstände R geschaltet ist.

Die Ausgänge des ersten und des zweiten Komparators K1, K2, sind an eine Extraktionsschaltung K0 zum Herausziehen des ursprünglichen Taktes T der übertragenden Vorrichtung C und zum Bereitstellen eines diesem Takt T entsprechenden internen Taktes jclk angelegt. Durch das Übertragen des externen Takts T in die integrierte Schaltungsanordnung J findet vorzugsweise eine direkte Synchronisierung der empfangenen externen Daten csd bzw. jd an den derart generierten internen Takt jclk statt. Komparator-Ausgangssignale ko, ki der beiden Komparatoren K1 bzw. K2 werden weiteren Schaltungskomponenten angelegt.

Ein weiterer Widerstand Rw ist über eine Source-Drain-Strecke eines ersten Transistors Tw zwischen die Signalspannung v und die Basisspannung vss geschaltet. Ein zweiter Transistor Ts ist mit seiner Source-Drain-Strecke direkt zwischen die Signalspannung v und die Basisspannung vss geschaltet. Unter anderem der weitere Widerstand Rw und die beiden Transistoren Tw, Ts bilden Komponenten einer Schalteinrichtung, welche derart ausgestaltet und/oder angesteuert ist, dass in einem Sendemodus über den Anschlusskontakt Daten jo der Schalteinrichtung J gesendet werden.

Im Wesentlichen erfolgt die Verfahrensweise zur Bestimmung des empfangenen Takts T, aus welchem der interne Takt jclk generiert wird, und der externen Daten csd, aus welchen die internen Daten jd der in der Schaltungsanordnung J generiert werden, ähnlich der Vorrichtung und Verfahrensweise gemäß DE 10 2006 022 985 A1.

Diese intern von der Schnittstelle JD generierten Daten jd und der interne Takt jclk sowie die zur übergeordneten Vorrichtung C zu übertragenden Daten jo werden der Steuereinrichtung JC angelegt, welche auf Basis insbesondere dieser empfangenen Daten jd mittels des Herunterziehtreibers JPDC davon abhängig die beiden Herunterziehsignale pdw, pds bereitstellt.

Diese beiden Herunterziehsignale pdw, pds dienen zur Signalisierung der eigentlich zu übertragenden Daten jo und werden der Schnittstelle JD angelegt. Wie Fig. 4 entnehmbar, wird das schwache Herunterziehsignal pdw an den ersten Transistor TW angelegt, welcher in Reihe mit dem weiteren Widerstand Rw zwischen die Basisspannung vss und die Signalspannung v geschaltet ist. Ein anliegendes schwaches Herunterziehsignal pdw bewirkt somit ein schwaches Herunterziehen der Signalspannung v. Das starke Herunterziehsignal pds wird hingegen an den zweiten Transistor Ts angelegt, welcher direkt zwischen die Basisspannung vss und die Signalspannung v geschaltet ist. Mittels der Herunterziehsignale pdw, pds werden somit die Gate-Anschlüsse der beiden Transistoren Tw bzw. Ts angesteuert.

Als besonderes Merkmal kann die integrierte Schaltungsanordnung neben der Komparatorschaltung K zusätzlich eine Testschnittstelle TFI bzw. Testschnittstellenschaltung für einen Testbetrieb aufweisen. Sowohl die Komparatorschaltung K als auch eine solche Testschnittstelle können vorteilhaft in der Schnittstellenschaltung JD integriert oder direkt über eigene Leitungen oder einen eigenen Bus daran geschaltet sein.

Optional ist die Basisspannung vss über einen Schalter schaltbar, wobei zum Schließen des Schalters ein Freigabesignal zum Aktivieren einer aktiven Betriebsart, insbesondere einer Testbetriebsart angelegt wird. Durch das Deaktivieren können die Komparatoren K1, K2 ausgeschaltet werden, wenn sich die integrierte Schaltung J nicht in der Betriebsart befindet, so dass weniger Strom verbraucht wird.

Die aktive Betriebsart wird vorzugsweise dadurch aktiviert, dass eine bestimmte Bitfolge in einem vorgegebenen Registerbereich, insbesondere in zwei EEPROM-Zellen, vorliegt oder über den Strom aus übertragenen Daten csd eine entsprechende Bitfolge empfangen wird. Vorzugsweise handelt es sich dabei, wie in Fig. 1 und 2 skizziert, um ein in den hohen Spannungszustand Vh gesetztes erstes Bit Bit1. Dieses erste Bit Bit1 folgt einer Abfolge von Nullen, welche durch ein Alternieren der Signalspannung v zwischen dem tiefen und dem mittleren Spannungszustand V1, Vm signalisiert werden. Die Abfolge der Nullen signalisiert einen inaktiven bzw. untätigen Zustand der übergeordneten Vorrichtung C.

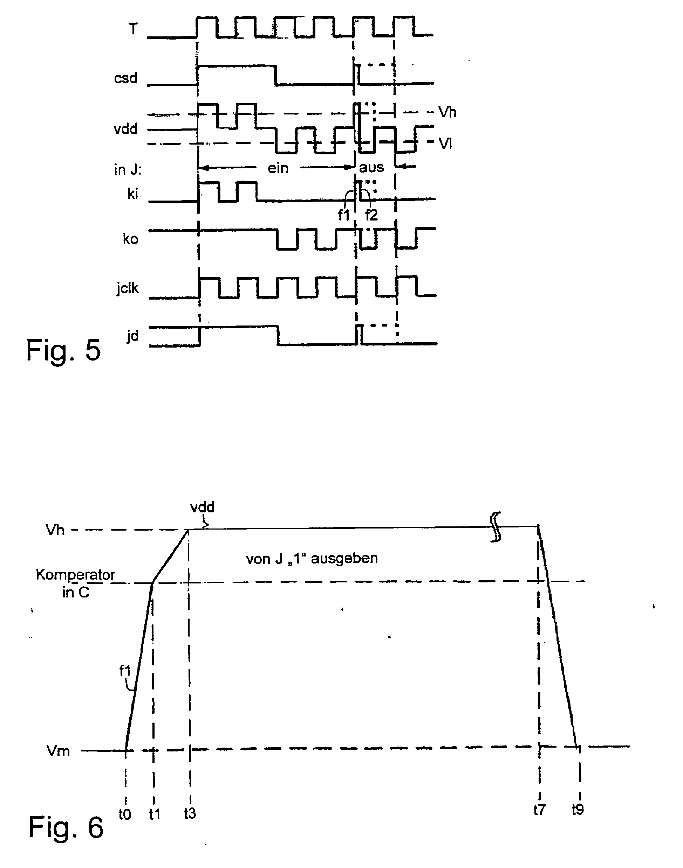

Fig. 5 zeigt beispielhafte Taktdiagramme für verschiedene Signale in einer solchen Schaltungsanordnung. Die erste Zeile zeigt den externen Takt T, welcher von der übergeordneten Vorrichtung C auf die Signalspannung v aufmoduliert wird. Die zweite Zeile zeigt die externen Daten csd, welche von der übergeordneten Vorrichtung C auf die Signalspannung v aufmoduliert werden. Die dritte Zeile zeigt die Signalspannung v mit den externen Daten csd und dem externen Takt T, welche aufmoduliert sind.

Die Modulation wird dabei derart vorgenommen, dass mit jeder zweiten Taktflanke des Takts T, d. h. mit jeder Taktperiode, entweder der erste Spannungspegel bzw. der tiefe Spannungszustand V1 für einen halben Takt angesteuert oder unterschritten oder der dritte Spannungspegel bzw. der hohe Spannungszustand Vh für einen halben Takt angesteuert oder überschritten wird. Durch eine kombinatorische Logik in der Schaltungsanordnung J werden solche die entsprechenden Spannungspegel ansteuernden bzw. überschreitenden oder unterschreitenden Abschnitte der Signalspannung v entsprechend dem hohen oder tiefen Signalverlauf des Signals für die externen, von der übergeordneten Vorrichtung C gesendeten Daten csd zugeordnet. Dargestellt sind zur Veranschaulichung in Fig. 5.

Nach der Übertragung in die Komparatorschaltung K ist am Ausgang des zweiten Komparators K2, das Signal ki der vierten Zeile abgreifbar, welches immer dann einen hohen Takt hat, wenn ein hoher Datenzustand der externen Daten csd vorliegt. Die fünfte Zeile zeigt den Signalverlauf bzw. das Ausgangssignal ko am Ausgang des ersten Komparators K1. Dann, wenn die externen Daten csd im tiefen Zustand sind, ist dieses Komparatorausgangssignal des ersten Komparators K1 entsprechend im tiefen Zustand. Aus diesen Ausgangssignalen ki, ko der beiden Komparatoren K1, K2 werden der in der sechsten Zeile dargestellte interne Takt jclk und die in der siebten Zeile dargestellten internen Daten jd rekonstruiert und für weitere Schaltungskomponenten der Schaltungsanordnung J bereitgestellt.

Die Signalfolge zur Aktivierung einer Betriebsart, insbesondere der Testbetriebsart kann somit gemäß einer Ausführungsform zusätzlich oder alternativ zu einem Rest oder einer Spannungsunterbrechung den an den beiden Anschlusskontakten S0, SDAT angelegten Spannungswerten der Signalspannung v entnommen werden. Im Fall einer ersten Inbetriebnahme wird die Testbetriebsart durch die sämtlich auf 0 voreingestellten Registerwerte automatisch aktiviert.

Außerdem skizziert ist in der in der siebten Zeile ein Sendevorgang der Schaltungsanordnung J an die übergeordnete Vorrichtung C dargestellt. Von der Schaltungsanordnung J werden z.B. Daten o der Schaltungsanordnung J über den Anschlusskontakte SDAT ausgegeben, an welchem die Signalspannung v anliegt.

Ermöglicht wird mit diesen Komponenten und den entsprechenden Komponenten in der übergeordneten Vorrichtung C eine Datenübertragung mit der insbesondere nachfolgenden Verfahrensweise.

Um eine logische Eins von der Schaltungsanordnung J, das heißt der den Takt T empfangenden Seite zu der den Takt T sendenden Seite zu senden, legt die den Takt T sendende übergeordnete Vorrichtung C zuerst am Ende des dritten Bits Bit3 und/oder beim Beginn des vierten Bits Bito einen hohen Spannungszustand Vh mit der einleitenden ansteigenden Flanke f1 als Signalspannung v an. Die Schaltungsanordnung J belässt diesen Spannungszustand v unverändert.

Um eine logische Null durch die Schaltungsanordnung J zu senden, legt die den Takt T übertragende übergeordnete Vorrichtung C wiederum einen hohen Spannungszustand Vh über die Dauer einer Bitperiode an. Zur Übertragung der logischen Null zieht jedoch die Schaltungsanordnung J die Signalspannung v herunter, vorzugsweise erst stark und dann schwach herunter. Am Ende der Bitdauer, das heißt einer halben Taktdauer des Takts T zieht die übergeordnete Vorrichtung C die Signalspannung v stark auf den mittleren Spannungszustand Vm.

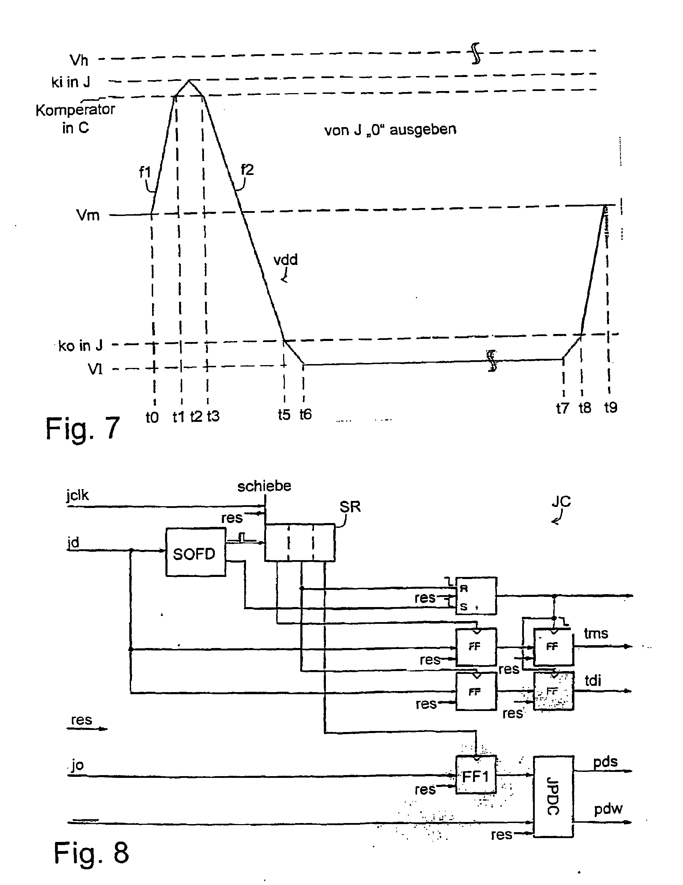

Entsprechend wird ein bevorzugter Zeitablauf zur Übertragung von zu sendenden Daten in mehrere Phasen gesplittet, wobei entsprechende Treiber ein- und ausgeschaltet werden, je nach dem, welchen logischen Wert das auszugebende Signal bzw. der auszugebende Datenwert der Daten jo hat. Beispielhaft ist dies anhand der Fig. 6 und 7 für die beiden logischen Zustände 1 bzw. 0 skizziert.

Fig. 6 zeigt beispielhaft den Fall, dass während des vierten Takts bzw. Bits Bito der logische Wert 1 als zu sendende Daten jo von der Schaltungseinrichtung J an die übergeordnete Vorrichtung C zu senden ist. Dargestellt ist über die Zeit t der Verlauf der Signalspannung v. Zu Beginn t0 wird entsprechend von dem mittleren Spannungszustand Vm mit der steigenden Flanke f1 gestartet. Dazu werden sowohl der starke als auch der schwache Hochziehtreiber CPUS, CPUW der übergeordneten Vorrichtung C eingeschaltet. Zu einem während der ansteigenden ersten Flanke f1 späteren Zeitpunkt t1 wird der starke Hochziehtreiber CPUS beim Erreichen einer vorgegebenen Spannung ausgeschaltet. Zu einem noch späteren Zeitpunkt t3 ist der hohe Spannungszustand Vh erreicht, wobei nur noch der schwache Hochziehtreiber CPUW der übergeordneten Vorrichtung C aktiv geschaltet ist. In diesem Spannungszustand verbleibt die Signalspannung v bis zu einem Zeitpunkt t7 kurz vor Ablauf des halben Taktzyklus des Takts T. Zu diesem Zeitpunkt t7 wird der schwache Hochziehtreiber CPUW ausgeschaltet und ein starker Mittentreiber in der übergeordneten Vorrichtung C eingeschaltet, um die Signalspannung v auf den mittleren Spannungszustand Vm zu ziehen. Dieser ist zu einem noch späteren Zeitpunkt t9 erreicht. Zugleich ist damit auch die Übertragung des logischen Werts 1 von der Schaltungsanordnung J zu der übergeordneten Vorrichtung C abgeschlossen.

Fig. 7 zeigt ein entsprechendes Diagramm für die Übertragung des logischen Werts 0 von der Schaltungsanordnung J zu der übergeordneten Vorrichtung C. Im Wesentlichen sind dabei die ersten Abläufe gleich wie bei dem Ablauf der ersten drei Zeitpunkte t0, t1, t3 gemäß Fig. 6. Jedoch erfasst der zweite Komparator K2 in der Schaltungsanordnung J die ansteigende Flanke f1 und signalisiert dies durch ein entsprechendes internes Taktsignal jclk und Datensignal jd an die Steuereinrichtung JC. Diese befindet sich zu diesem Zeitpunkt in einem Zustand, bei dem der starke und der schwache Herunterziehtreiber aktiviert werden, so dass die beiden Transistoren Tw, Ts aktiviert werden. Dies bewirkt ein Herunterziehen der Signalspannung v. Zu einem nachfolgenden Zeitpunkt t3 wird dies durch einen entsprechenden Komparator in der übergeordneten Vorrichtung C erfasst, woraufhin die übergeordnete Vorrichtung C ihren schwachen Hochziehtreiber CPUS bei einem entsprechenden Komparatorsignal gleich 0 ausschaltet. Dem entspricht der Spannungszustand für den zeitlichen Punkt t3 der Signalspannung v. Demzufolge fällt die Signalspannung v in Richtung des tiefen Spannungszustands Vl ab, was durch die zweite Flanke f2 erkennbar ist. Kurz vor Erreichen des tiefen Spannungszustands Vl wird durch den ersten Komparator K1 der Schaltungsanordnung J ein entsprechendes Vergleichssignal als das Ausgangssignal ko ausgegeben, woraufhin deren Steuereinrichtung JC den starken Herunterziehtreiber JPDS ausschaltet. Durch den schwachen Herunterziehtreiber JPDW wird die Signalspannung v weiter bis zu dem Tiefenspannungszustand V1 heruntergezogen, was für einen nachfolgenden Zeitpunkt t6 skizziert ist. In diesem Spannungszustand Vl verbleibt die Signalspannung v bis zu einem Zeitpunkt t7 kurz vor Ablauf der halben Periode des Taktes T. Zu dem siebten Zeitpunkt t7 wird der starke Mittentreiber eingeschaltet, so dass die Signalspannung v wieder auf den mittleren Spannungszustand Vm ansteigt.

Kurz nach Beginn des Ansteigens wird dies durch den ersten Komparator K1 erfasst. Aufgrund eines entsprechenden Vergleichssignals des ersten Komparators K1, welches ein Überschreiten eines entsprechenden unteren Schwellenwertes signalisiert, wird zu einem kurz darauf nachfolgenden Zeitpunkt t8 der schwache Herunterziehtreiber JPDW ausgeschaltet. Zum skizzierten danach folgenden Zeitpunkt t9 hat die Signalspannung v wieder den mittleren Spannungszustand Vm erreicht, und die Übertragung einer logischen Null von der Schaltungsanordnung J zu der übergeordneten Vorrichtung C ist abgeschlossen.

Fig. 8 zeigt beispielhaft Komponenten einer bevorzugten Steuereinrichtung JC der integrierten Schaltungsanordnung. Angelegt werden den skizzierten Komponenten der aus der Übertragung gewonnene interne Takt jclk und die empfangenen Daten jd. Die empfangenen Daten werden einem Modul zur Detektion eines Sendebeginns SOFD angelegt. Bei Detektion eines empfangenen Werts wird dieser einem Schieberegister SR angelegt. Das Schieberegister SR schiebt die angelegten Werte mit jedem Takt jclk um eine Position weiter. Ein dritter Registerplatz des Schieberegisters SR liegt an einem Takteingang eines Flipflops FF1 an, welchem der Zustand bzw. logische Wert 0 oder 1 der auszugebenden Daten jo anliegt. Ein Ausgangswert des Flipflops FF1 wird der Herunterziehsteuerung JPDC angelegt, welcher außerdem der Ausgangswert bzw. das Ausgangssignal ko des ersten Komparators K1 anliegt. Weitere Komponenten dienen zum Ausgeben eines Taktsignals TCK und von Werten dbit0, dbit1 des zweiten und des dritten Bits Bit2, Bit3, das heißt zum Ausgeben der empfangenen und rekonstruierten Daten jd. Mittels eines Rücksetzsignals res können die Komponenten zurückgesetzt werden.

Gemäß alternativer Ausführungsformen können auch drei oder mehr Anschlusskontakte an der Schaltungsanordnung vorgesehen werden. Insbesondere kann zum bidirektionalen Übertragen von Daten, wie es vorstehend beschrieben ist, auch eine andere Spannung als die vorliegend beispielhaft genannte Signalspannung v verwendet werden.

Auch muss nicht zwingend eine Spannung mit auf niedrigem Spannungspegel dominanter Kommunikationsleitung eingesetzt werden. Auch eine Anordnung mit umgekehrten Spannungszuständen ist denkbar.

Vorteilhaft anwendbar ist eine solche Verfahrensweise nicht nur im Rahmen der Prüfung integrierter Schaltungsanordnungen mittels lediglich zwei Spannungsanschlüssen sondern auch im Rahmen weiterer Anwendungen. Neben der seriellen Datenübertragung bieten sich bei einer Applikationsentwicklung Ausgestaltungen als so genanntes Debug-Interface an. Auch eine Programmierschnittstelle (Flash - EEPROM) oder eine Testschnittstelle für Produktionstests sind umsetzbar.

## Patentansprüche

1. Integrierte Schaltungsanordnung (J)
- mit Anschlusskontakten (S0, SDAT) für einen seriellen Daten- und/oder Signalaustausch mit externen Komponenten und Vorrichtungen (C) und
- mit einer Steuereinrichtung (JC) und/oder einer seriellen Schnittstelle (JD) zum mittels eines Takts (T) getakteten Empfangen von Daten (jd) mittels einer zwischen zumindest einem tiefen, einem mittleren und einem hohen Spannungszustand (Vl, Vm, Vh) modulierten Signalspannung (v) an einem solchen Anschlusskontakt (SDAT),
**dadurch gekennzeichnet, dass**
- die Steuereinrichtung (JC) und/oder die Schnittstelle (JD) eine Schalteinrichtung (Ts, Tw, Rw) aufweisen, wobei diese derart ausgestaltet und/oder angesteuert sind, dass in einem Sendemodus über diesen Anschlusskontakt (SDAT) Daten (jo) gesendet werden, indem die Schalteinrichtung (Ts, Tw, Rw) nach Empfang einer von einem der Spannungszustände (Vm) in einen anderen der Spannungszustände (Vh) wechselnden Flanke (f1) diesen anderen der Spannungszustände vor zeitlichem Ablauf eines halben Taktzyklus des Takts (T) in einen der aus Sicht dieses anderen der Spannungszustände (Vh) verschiedenen der Spannungszustände (Vl) zieht.

2. Schaltungsanordnung nach Anspruch 1, bei der die Steuereinrichtung (JC) und/oder die Schnittstelle (JD) derart ausgestaltet und/oder angesteuert sind, dass in dem einen Sendemodus über diesen Anschlusskontakt (SDAT) Daten (jo) gesendet werden, indem die Schalteinrichtung (Ts, Tw, Rw) nach Empfang einer von dem mittleren Spannungszustand (Vm) in den höheren oder den tieferen Spannungszustand (Vh; Vl) wechselnden Flanke (f1) den Spannungszustand vor zeitlichem Ablauf eines halben Taktzyklus des Takts (T) in den aus Sicht des mittleren Spannungszustands (Vm) entgegengesetzten des tieferen oder höheren Spannungszustands (Vl; Vh) zieht.

3. Schaltungsanordnung nach Anspruch 1 oder 2 mit einer Komparatorschaltung (K), welche ausgestaltet und/oder angesteuert ist sowohl der Signalspannung (v) aufmodulierte Daten (csd) als für die Schaltungsanordnung interne Daten (jd) als auch einen der Signalspannung (v) aufmodulierten Takt (T) als für die Schaltungsanordnung internen Takt (T*) zu extrahieren.

4. Schaltungsanordnung nach einem vorstehenden Anspruch mit einer schaltungsanordnungsseitigen Sendesteuerung (JC), welche einen Zähler zum Zählen einer Anzahl von Takten mit von der Vorrichtung (C) gesendeten Daten oder Spannungszuständen zu aufweist und Komponenten zum Senden der Daten (jo) an die Vorrichtung (C) bei Erreichen eines festen oder vorgebbar festen Zählerwerts des Zählers aufweist.

5. Schaltungsanordnung nach einem vorstehenden Anspruch mit einer Transistoranordnung (Tw, Rw) zum schwachen Ziehen der Signalspannung in den anderen, insbesondere entgegengesetzten Spannungszustand (Vl) und einer Transistoranordnung (Ts) zum starken Ziehen der Signalspannung in den anderen, insbesondere entgegengesetzten Spannungszustand (V1).

6. Schaltungsanordnung nach einem vorstehenden Anspruch, welche für eine Testbetriebsart ausgelegt und/oder gesteuert ist zum Anlegen des mit der Signalspannung angelegten Takts (T) als internen Takt (T*) an Komponenten der Schaltungsanordnung.

7. Schaltungsanordnung nach einem vorstehenden Anspruch mit einer Schalteinrichtung (SW) zum Aktivieren einer Komparatorschaltung (K) zum Analysieren der Signalspannung (v) und/oder einer Test-Schnittstelle (TIF) in einer Testbetriebsart und/oder bei einer Entwicklung der Schaltungsanordnung und/oder bei einer Entwicklung der Software der Schaltungsanordnung und/oder bei einer Bandendeprogrammierung und/oder bei einer Fehlersuche in einer durch die Schaltungsanordnung realisierten Applikation.

8. Schaltungsanordnung nach einem vorstehenden Anspruch, die ausgelegt und/oder gesteuert ist zum Ausgeben von durch die Schaltungsanordnung oder eine daran angeschlossene Anordnung bereitgestellten Daten, auch von Mess- oder Sensordaten, als den in dem Sendemodus über den Anschlusskontakt (SDAT) zu sendenden Daten (jo).

9. Vorrichtung (C)
- mit Anschlusskontakten (S0, SDAT) für einen seriellen Daten- und/oder Signalaustausch mit einer integrierten Schaltungsanordnung (J), insbesondere einer Schaltungsanordnung nach einem vorstehenden Anspruch,
- mit einer Steuereinrichtung (CC) und/oder einer seriellen Schnittstelle (CD) zum mittels eines Takts (T) getakteten Senden von Daten (csd) durch Modulation einer Signalspannung (v) zwischen zumindest einem tiefen, einem mittleren und einem hohen Spannungszustand (Vl, Vm, Vh) an einem solchen Anschlusskontakt (SDAT),
**dadurch gekennzeichnet, dass**
- die Schnittstelle (CD) derart ausgestaltet und/oder angesteuert ist, dass diese in einem Empfangsmodus von einem der Spannungszustände (Vm) in einen anderen der Spannungszustände (Vh) wechselt und diese zumindest bei einem Ziehen diesen anderen der Spannungszustände vor zeitlichem Ablauf eines halben Taktzyklus des Takts (T) in einen der aus Sicht dieses anderen der Spannungszustände (Vh) verschiedenen der Spannungszustände (Vl) durch die Schaltungsanordnung (J) einen Empfang von Daten (jo) von der Schaltungsanordnung (J) erfasst.

10. Vorrichtung (C) nach Anspruch 9, bei der die Schnittstelle (CD) derart ausgestaltet und/oder angesteuert ist, dass diese in einem Empfangsmodus von dem mittleren Spannungszustand (Vm) in den höheren oder den tieferen Spannungszustand (Vh; Vl) wechselt und zumindest bei einem Ziehen des Spannungszustands vor zeitlichem Ablauf eines halben Taktzyklus des Takts (T) in den aus Sicht des mittleren Spannungszustands (Vm) entgegengesetzten des tieferen oder höheren Spannungszustands (Vl; Vh) durch die Schaltungsanordnung (J) einen Empfang von Daten (jo) von der Schaltungsanordnung (J) erfasst.

11. Vorrichtung (C) nach Anspruch 9 oder 10, bei der die Schnittstelle ausgelegt und/oder angesteuert ist zum rezessiven Anlegen der Signalspannung (v) beim Wechsel in den anderen der Spannungszustände, insbesondere in den höheren oder den tieferen Spannungszustand (Vh; Vl) während des Empfangsmodus.

12. System zum Übertragen von Daten oder Signalen über einen gemeinsamen mit Anschlusskontakt (SDAT) mit einer integrierten Schaltungsanordnung nach einem der Ansprüche 1 bis 8 und mit einer Vorrichtung (C) nach einem der Ansprüche 9 bis 11.

13. Verfahren zum seriellen übertragen von Daten (csd) durch Modulation einer Signalspannung (v) zwischen zumindest einem tiefen, einem mittleren und einem hohen Spannungszustand (Vl, Vm, Vh) an einem Anschlusskontakt (SDAT) einer integrierten Schaltungsanordnung (J),
**dadurch gekennzeichnet, dass**
- in einem Empfangsmodus durch eine an den Anschlusskontakt (SDAT) geschaltete Vorrichtung (C) an diesen Anschlusskontakt (SDAT) die Signalspannung (v) mit einer von einem der Spannungszustände (Vm) in einen anderen der Spannungszustände (Vh) wechselnden Flanke (f1) angelegt wird und
- durch die Schaltungsanordnung (J) zum Senden nach Empfang der Flanke (f1) die Signalspannung (v) vor zeitlichem Ablauf eines halben Taktzyklus des Takts in einen der aus Sicht dieses anderen der Spannungszustände (Vh) verschiedenen der Spannungszustände (Vl) gezogen wird.

14. Verfahren nach Anspruch 13, bei dem durch die Vorrichtung (C) die Flanke (f1) an den Anschlusskontakt (SDAT) angelegt wird und durch die Schaltungsanordnung (J)
- zum Senden eines ersten Datenzustands nach Empfang der Flanke (f1) die Signalspannung (v) in den aus Sicht des mittleren Spannungszustands (Vm) als dem einen der Spannungszustände entgegengesetzten des tieferen oder höheren Spannungszustands (Vh) als dem einen anderen der Spannungszustände gezogen wird und
- zum Senden eines zweiten Datenzustands nach Empfang der Flanke (f1) die Signalspannung (v) in dem durch die Vorrichtung (C) angelegten Spannungszustand (Vh) belassen wird.

15. Verfahren nach Anspruch 13 oder 14, bei dem die Signalspannung (v) durch die übergeordnete Vorrichtung (C) mittels eines Takts (T) getaktet verändert wird und bei dem die Signalspannung (v) durch die integrierte Schaltungsanordnung (J) nach Empfang der Flanke (f1) die Signalspannung (v) vor zeitlichem Ablauf eines halben Taktzyklus des Takts (T) in den aus Sicht des mittleren Spannungszustands (Vm) als dem einen der Spannungszustände entgegengesetzten des tieferen oder höheren Spannungszustands (Vh) als dem einen anderen der Spannungszustände gezogen wird.

16. Verfahren nach einem der Ansprüche 13 bis 15 mit einem Protokoll, gemäß dem eine feste Anzahl von aufeinander folgenden Zeitpunkten oder Takten (Bit1 - Bit3) durch die Vorrichtung (C) gesendet werden darf und danach oder abwechselnd damit eine feste Anzahl von aufeinander folgenden Zeitpunkten oder Takten, zumindest ein Takt (Bito), durch die Schaltungsanordnung (J) gesendet werden darf.

17. Verfahren nach einem der Ansprüche 13 bis 16, bei dem die Vorrichtung (C) zum Übertragen eines Takts (T) an die Schaltungsanordnung (J) die Signalspannung (v) innerhalb eines Taktzyklus (T) getaktet verändert durch einen Wechsel des Spannungszustands der Signalspannung (v) zwischen zweien des mittleren Spannungszustands (Vm), des höheren Spannungszustands oder des tieferen Spannungszustand (Vl) und durch einen Wechsel des Spannungszustands zurück.

## Claims

1. Integrated circuit arrangement (J) comprising
- connecting contacts (S0, SDAT) for a serial data and/or signal exchange with external components and devices (C) and
- a control device (JC) and/or a serial interface (JD) for reception, which is periodic by means of clock pulse (T), of data (jd) by means of a signal voltage (v), which is modulated between at least one low, medium and high voltage state (V1, Vm, Vh), at such a connection contact (SDAT),
**characterised in that**
- the control device (JC) and/or the interface (JD) comprises or comprise a switching device (Ts, Tw, Rw), wherein these are so designed and/or activated that in a transmitting mode data (jo) is transmitted by way of this connection contact (SDAT) **in that** the switching device (Ts, Tw, Rw) after reception of a flank (f1) changing from one of the voltage states (Vm) to another one of the voltage states (Vh) draws this other one of the voltage states, before expiry of half a clock cycle of the clock pulse (T), into one of the different ones of the voltage states (V1) from the standpoint of this other one of the voltage states (Vh).

2. Circuit arrangement according to claim 1, in which the control device (JC) and/or the interface (JD) is or are designed and/or activated in such a manner that data (jo) is transmitted in the one transmitting mode by way of this connection contact (SDAT) in that the switching device (Ts, Tw, Rw) after a reception of a flank (f1) changing from the medium voltage state (Vm) to the higher or lower voltage state (Vh; V1) draws the voltage state, before expiry of half a clock cycle of the clock pulse (T), into the opposite one of the lower or higher voltage state (V1; Vh) from the standpoint of the medium voltage state (Vm).

3. Circuit arrangement according to claim 1 or 2, comprising a comparator circuit (K) which is designed and/or activated to extract not only data (csd), which is modulated on the signal voltage (v), as internal data (jd) for the circuit arrangement, but also a clock pulse (T), which is modulated on the signal voltage (v), as an internal clock pulse (T*) for the circuit arrangement.

4. Circuit arrangement according to any one of the preceding claims, comprising a transmission control (JC), which is at the circuit arrangement side and which comprises a counter for counting a number of clock pulses with data or voltage states transmitted by the device (C) and components for transmitting the date (jo) to the device (C) on attainment of a fixed or predeterminable fixed count value of the counter.

5. Circuit arrangement according to any one of the preceding claims, comprising a transistor arrangement (Tw, Rw) for weak drawing of the signal voltage into the other, in particular opposite, voltage state (V1) and a transistor arrangement (Ts) for strong drawing of the signal voltage into the other, in particular opposite, voltage state (V1).

6. Circuit arrangement according to any one of the preceding claims, which is designed and/or controlled for a test operation mode for application of the clock pulse (T), which is applied with the signal voltage, as an internal clock pulse (T*) to components of the circuit arrangement.

7. Circuit arrangement according to any one of the preceding claims, comprising a switching device (SW) for activation of a comparator circuit (K) for analysing the signal voltage (v) and/or a test interface (TIF) in a test operating mode and/or in the case of development of the circuit arrangement and/or in the case of development of the software of the circuit arrangement and/or in the case of band end programming and/or in the case of a fault search in an application realised by the circuit arrangement.

8. Circuit arrangement according to any one of the preceding claims, which is designed and/or controlled for output of data provided by the circuit arrangement or an arrangement connected therewith, also of measuring or sensor data, as the data (jo) to be transmitted in the transmitting mode by way of the connection contact (SDAT).

9. Device (C) comprising
- connection contacts (S0, SDAT) for a serial data and/or signal exchange with an integrated circuit arrangement (J), particularly a circuit arrangement according to any one of the preceding claims, and
- a control device (CC) and/or a serial interface (CD) for transmission, which is periodic by means of a clock pulse (T), of data (csd) by modulation of a signal voltage (v) between at least one low, medium and high voltage state (V1, Vm, Vh) at such a connection contact (SDAT),
**characterised in that**
- the interface (CD) is designed and/or activated in such a manner that this in a receiving mode changes from one of the voltage states (Vm) into another one of the voltage states (Vh) and this detects reception of data (jo) from the circuit arrangement (J) at least when this other one of the voltage states is drawn, before expiry of half a clock cycle of the clock pulse (T), by the circuit arrangement (J) into one of the different ones of the voltage states (V1) from the standpoint of this other one of the voltage states (Vh).

10. Device (C) according to claim 9, in which the interface (CD) is designed and/or activated in such a manner that this in a receiving mode changes from the medium voltage state (Vm) to the higher or lower voltage state (Vh; V1) and detects reception of data (jo) from the circuit arrangement (J) at least when the voltage state is drawn, before expiry of half a clock cycle of the clock pulse (T), by the circuit arrangement (J) into the opposite one of the lower or higher voltage state (V1; Vh) from the standpoint of the medium voltage state (Vm).

11. Device (C) according to claim 9 or 10, in which the interface is designed and/or activated for recessive application of the signal voltage (v) on change to the other one of the voltage states, particularly into the higher or lower voltage state (Vh; V1), during the receiving mode.

12. System for transmission of data or signals by way of a common connecting contact (SDAT) with an integrated circuit arrangement according to any one of claims 1 to 8 and with a device (C) according to any one of claims 9 to 11.

13. Method for serial transmission of data (csd) by modulation of a signal voltage (v) between at least one low, medium and high voltage state (V1, Vm, Vh) at a connecting contact (SDAT) of an integrated circuit arrangement (J),
**characterised in that**
- in a receiving mode the signal voltage (v) with a flank (f1) changing from one of the voltage states (Vm) into another one of the voltage states (Vh) is applied by a device (C), which is connected with the connecting contact (SDAT), to this connecting contact (SDAT) and
- for transmission of reception of the flank (f1) the signal voltage (v) is drawn, before expiry of half a clock cycle of the clock pulse, by the circuit arrangement (J) into one of the different ones of the voltage states (V1) from the standpoint of this other one of the voltage states (Vh).

14. Method according to claim 13, in which the flank (f1) is applied to the connecting contact (SDAT) by the device (C) and, by way of the circuit arrangement (J),
- for transmission of a first data state after reception of the flank (f1) the signal voltage (v) is drawn into the opposite - from the standpoint of the medium voltage state (Vm) as one of the voltage states - one of the lower or higher voltage state (Vh) as the other one of the voltage states, and
- for transmission of a second data state after reception of the flank (f1) the signal voltage (v) is left in the voltage state (Vh) applied by the device (C).

15. Method according to claim 13 or 14, in which the signal voltage (v) is periodically changed by means of a clock pulse (T) by the superordinate device (C) and in which the signal voltage (v) after reception of the flank (f1) is drawn by the integrated circuit arrangement (J), before expiry of a half clock cycle of the clock pulse (T), into the opposite - from the standpoint of the medium voltage state (Vm) as one of the voltage states - one of the lower or higher voltage state (Vh) as the other one of the voltage states.

16. Method according to any one of claims 13 to 15, comprising a protocol according to which a fixed number of successive time instants or clock pulses (Bit1 - Bit3) may be transmitted by the device (C) and thereafter or in alternation therewith a fixed number of successive time instants or clock pulses, at least one clock pulse (Bito), may be transmitted by the circuit arrangement (J).

17. Method according to any one of claims 13 to 16, in which the device (C) for transmission of a clock pulse (T) to the circuit arrangement (J) periodically changes the signal voltage (v) within a clock pulse cycle (T) by a change of the voltage state of the signal voltage (v) between two of the medium voltage state (Vm), the higher voltage state and the lower voltage state (V1) and by a change back of the voltage state.

## Revendications

1. Agencement de commutation (J) intégré comprenant :
- des contacts de raccordement (S0, SDAT), pour un échange de données et/ou de signaux série avec des composants et des dispositifs (C) externes, et
- un dispositif de commande (JC) et/ou une interface série (JD), pour la réception, cadencée au moyen d'un rythme (T), à un tel contact de raccordement (SDAT), de données (jd) au moyen d'une tension de signal (v) modulée entre au moins un état de tension bas, un état de tension moyen et un état de tension haut (Vl, Vm, Vh),
**caractérisé en ce que** :
- le dispositif de commande (JC) et/ou l'interface (JD) présente(nt) un dispositif de commutation (Ts, Tw, Rw), celui-ci/ceux-ci étant réalisé(s) et/ou commandé(s) de manière que, en un mode émission, des données (jo) soient envoyées par l'intermédiaire de ce contact de raccordement (SDAT), **en ce que**, après réception d'un flanc (f1) marquant le passage d'un des états de tension (Vm) en un autre des états de tension (Vh), le dispositif de commutation (Ts, Tw, Rw), avant l'expiration temporelle d'un demi cycle de période du rythme (T), tire cet autre des états de tension en l'un des états de tension (Vl) différent par rapport à cet autre des états de tension (Vh).

2. Agencement de commutation selon la revendication 1, dans lequel le dispositif de commande (JC) et/ou l'interface (JD) est/sont réalisé(s) et/ou commandé(s) de manière que, dans le premier mode en émission, des données (jo) soient envoyées par l'intermédiaire de ce contact de raccordement (SDAT), en ce que, après réception d'un flanc (f1) marquant le passage de l'état de tension moyen (Vm) en l'état de tension plus élevé ou plus bas (Vh ; Vl), le dispositif de commutation (Ts, Tw, Rw), avant expiration temporelle d'un demi-cycle de période du rythme (T), tire l'état de tension en l'état de tension plus bas ou plus élevé (Vh ; Vl), opposé par rapport à l'état de tension moyen (Vm).

3. Agencement de commutation selon la revendication 1 ou 2, avec un circuit comparateur (K), réalisé et/ou commandé pour extraire aussi bien des données (csd), injectées au moyen d'une technique de modulation de la tension de signal (v), à titre de données (jd) internes pour l'agencement de commutation, qu'un rythme (T), injecté au moyen d'une technique de modulation de la tension de signal (v), à titre de rythme (T*) interne pour l'agencement de commutation.

4. Agencement de commutation selon l'une des revendications précédentes, avec une commande d'émission (JC) située côté agencement de commutation, présentant un compteur pour compter un nombre de cycles avec des données ou des états de tension envoyé(e)s par le dispositif (C), et des composants pour envoyer les données (jo) au dispositif (C) à l'atteinte d'une valeur de compteur, fixe ou pouvant être prédéterminée, du compteur.

5. Agencement de commutation selon l'une des revendications précédentes, avec un agencement à transistor (Tw, Rw), pour tirer faiblement la tension de signal dans l'autre état de tension (Vl), en particulier opposé, et un agencement à transistor (Ts) pour tirer fortement la tension de signal dans l'autre état de tension (Vl), en particulier opposé.

6. Agencement de commutation selon l'une des revendications précédentes, conçu et/ou commandé pour un type de fonctionnement d'essai, pour application du rythme (T) appliqué à la tension de signal, en tant que rythme interne (T*), à des composants de l'agencement de commutation.

7. Agencement de commutation selon l'une des revendications précédentes, avec un dispositif de commutation (SW), pour activer un circuit de comparateur (K) pour analyser la tension de signal (v), et/ou une interface de test (TIF) dans un type de fonctionnement d'essai et/ou lors d'un développement de l'agencement de commutation et/ou lors d'un développement du logiciel de l'agencement de commutation et/ou lors d'une programmation de fin de bande et/ou lors d'une recherche d'erreurs dans une application réalisée au moyen de l'agencement de commutation.

8. Agencement de commutation selon l'une des revendications précédentes, conçu et/ou commandé pour éditer des données fournies par l'agencement de commutation ou un agencement y étant raccordé, également des données de mesure ou de capteur, en tant que données (jo) à envoyer par l'intermédiaire du contact de raccordement (SDAT) dans le mode en émission.

9. Dispositif (C) comprenant :
- des contacts de raccordement (S0, SDAT) pour un échange de données et/ou de signaux avec un agencement de commutation (J) intégré, en particulier un agencement de commutation selon l'une des revendications précédentes,
- un dispositif de commande (CC) et/ou une interface série (CD), pour l'envoi, cadencé à l'aide d'un rythme (T), à un tel contact de raccordement (SDAT) de données (csd) par modulation d'une tension de signal (v) entre au moins un état de tension bas, un état de tension moyen et un état de tension haut (Vl, Vm, Vh), haut,
**caractérisé en ce que** :
- l'interface (CD) est réalisée et/ou commandée de manière que celle-ci, en un mode réception, passe d'un des états de tension (Vm) en un autre des états de tension (Vh) et celle-ci, au moins lors d'un tirage de cet autre des états de tension, avant l'expiration temporelle d'un demi cycle du rythme (T), détecte, au moyen de l'agencement de commutation (J), une réception de données (jo) par l'agencement de commutation (J), en l'un des états de tension (Vl), différent par rapport à cet autre des états de tension (Vh).

10. Dispositif (C) selon la revendication 9, dans lequel l'interface (CD) est réalisée et/ou commandée de manière que celle-ci, en un mode en réception, passe de l'état de tension moyen (Vm) en l'état de tension plus élevé ou plus bas (Vh ; Vl) et, au moins lors d'un tirage de l'état de tension, avant expiration temporelle d'un demi cycle du rythme (T), détecte, au moyen de l'agencement de commutation (J), une réception de données (jo) par l'agencement de commutation (J), dans les états de tension plus bas ou plus élevé (Vl ; Vh) opposés par rapport à l'état de tension moyen (Vm).

11. Dispositif (C) selon la revendication 9 ou 10, dans lequel l'interface (CD) est conçue et/ou commandée pour l'application récessive de la tension de signal (v), lors du passage dans l'autre des états de tension, en particulier dans l'état de tension plus élevé ou plus bas (Vh ; Vl) pendant le mode réception.

12. Système, pour transmettre des données ou des signaux par l'intermédiaire d'un agencement de commutation commun, avec un contact de raccordement (SDAT), avec un agencement de commutation intégré selon l'une des revendications 1 à 8 et avec un dispositif (C) selon l'une des revendications 9 à 11.

13. Procédé pour la transmission série de données (csd), par modulation d'une tension de signal (v) entre au moins un état de tension bas, un état de tension moyen et un état de tension haut (Vl, Vm, Vh), à un contact de raccordement (SDAT) d'un agencement de commutation (J) intégré,
**caractérisé en ce que** :
- dans un mode réception, au moyen d'un dispositif (C) branché au contact de raccordement (SDAT), la tension de signal (v) est appliquée à ce contact de raccordement (SDAT) avec un flanc (f1) marquant le passage d'un des états de tension (Vm) dans un autre des états de tension (Vh), et
- au moyen de l'agencement de commutation (J), pour l'envoi après réception du flanc (f1), avant l'expiration temporelle d'un demi cycle du rythme, la tension de signal (v) est tirée dans un état de tension différent des états de tension (V1), par rapport à cet autre des états de tension (Vh).

14. Procédé selon la revendication 13, dans lequel, au moyen du dispositif (C), le flanc (f1) est appliqué au contact de raccordement (SDAT) et, au moyen de l'agencement de commutation (J),
- pour l'envoi d'un premier état de données après réception du flanc (f1), la tension de signal (v) est tirée dans celui, du plus bas ou du plus haut état de tension (Vh), opposé, par rapport à l'état de tension (Vm) moyen, en tant que le premier des états de tension, l'état de tension plus bas ou plus élevé (Vh), par rapport à l'autre des états de tension, et
- pour l'envoi d'un deuxième état de données, après réception du flanc (f1), la tension de signal (v) est laissée dans l'état de tension (Vh) appliqué par le dispositif (C).

15. Procédé selon la revendication 13 ou 14, dans lequel la tension de signal (v) est modifiée de manière cadencée à l'aide d'un rythme (T), au moyen du dispositif (C) hiérarchiquement supérieur, et dans lequel la tension de signal (v), au moyen de l'agencement de commutation (J) intégré, après réception du flanc (f1), avant expiration temporelle d'un demi cycle de rythme du rythme (T), la tension de signal (v) est tirée dans celui, opposé au premier des états de tension, par rapport à l'état de tension moyen (Vm), de l'état de tension plus bas ou plus élevé (Vh) que l'autre des états de tension.

16. Procédé selon l'une des revendications 13 à 15, avec un protocole selon lequel un nombre fixe de moments ou d'impulsions (Bit1 à Bit 3), se suivant les un(e)s les autres, peut être envoyé par le dispositif (C) et, ensuite ou alternativement, ainsi, un nombre fixe de moments ou d'impulsions, se suivant les un(e)s les autres, au moins une impulsion (Bito), peut être envoyé par l'agencement de commutation (J).

17. Procédé selon l'une des revendications 13 à 16, dans lequel le dispositif (C), pour transmettre une impulsion (T) à l'agencement de commutation (J), modifie de façon cadencée la tension de signal (v) dans les limites d'un cycle de cadencement (T), au moyen d'un changement de l'état de tension de la tension de signal (v) entre deux de l'état de tension moyen (Vm), de l'état de tension haut ou de l'état de tension bas (Vl), et retour par un changement de l'état de tension.
